# EUROPEAN PATENT APPLICATION

(11) **EP 1 981 042 A1**
(43) Date of publication of application: **15.10.2008**
(21) Application number: 07122672.4
(22) Date of filing: 07.12.2007
(51) Int. Cl.: H01F 1/00, H01F 10/13, H01F 5/00, H01F 17/00, H01F 27/28, H01F 41/04, C23C 14/00

(54) **Inductive devices with granular magnetic materials**

(30) Priority: 28.03.2007 US 907303 P; 11.07.2007 US 822918
(71) Applicant: Heraeus, Inc., Chandler AZ 85226 (US)
(72) Inventor: Das, Anirban, Chandler, AZ 85225 (US); Li, Shin Hwa, Chandler, AZ 85248 (US); Racine, Michael Gene, Phoenix, AZ 85044 (US)
(74) Representative: Hill, Justin John

(57) **Abstract**

An inductive device is provided, comprising a conductor configured in a spiral and a first layer of granular magnetic material having a plurality of magnetic grains embedded in an amorphous ceramic matrix. The amorphous ceramic matrix has a dielectric constant greater than 3. A transformer is also provided, comprising a core and a first inductor. The first inductor includes a first conductor configured in a spiral surrounding a first portion of the core, and a first layer of granular magnetic material. The transfomner further comprises a second inductor. The second inductor includes a second conductor configured in a spiral surrounding a second portion of the core, and a second layer of granular magnetic material. The first and second layers of granular magnetic material have a plurality of magnetic grains embedded in an amorphous ceramic matrix. The amorphous ceramic matrix has a dielectric constant greater than 3.

## Description

### CROSS-REFERENCE TO RELATED APPLICATION

The present application claims the benefit of priority under 35 U.S.C. § 119 from U.S. Provisional Patent Application Serial No. 60/907,303 entitled "SOFT MAGNETIC ALLOY THIN FILMS FOR INTEGRATED INDUCTORS, TRANSFORMERS AND OTHER HIGH FREQUENCY APPLICATIONS," filed on March 28, 2007, the disclosure of which is hereby incorporated by reference in its entirety for all purposes.

### STATEMENT REGARDING FEDERALLY SPONSORED RESEARCH OR DEVELOPMENT

Not applicable.

### FIELD OF THE INVENTION

The present invention generally relates to inductive devices and, more specifically, relates to inductive devices with granular magnetic materials.

### BACKGROUND OF THE INVENTION

Integrated on-chip and on-package inductors are often provided with thin films of a magnetic material to improve their inductance. When a high-permeability magnetic material is placed near a conductor carrying electric current, the inductance in the conductor is increased by a factor of the relative permeability µᵣ. If the relative permeability is real *(i.e.,* does not show any magnetic loss), then the gain in inductance can be significant.

In higher-frequency applications (e.g., operating above about 1 GHz), the magnetic materials used in these integrated devices experience increasing magnetic losses (e.g., an increasing imaginary component of relative permeability). Eddy currents in the magnetic materials contribute to these high frequency magnetic losses, as they contribute significantly to damping effects. These eddy currents are the result of magnetic materials with insufficiently high resistivity. While some amorphous magnetic alloys enjoy higher resisitivity, this comes at a cost of lower magnetization (and accordingly lower performance in inductive applications.) Accordingly, to improve the high-frequency performance of integrated inductors, transformers and the like, it is desirable to provide magnetic materials with high resistivity and high magnetization for use therein.

### SUMMARY OF THE INVENTION

According to one aspect of the present invention, granular magnetic alloy films are provided for use in integrated inductors, transformers, and other high frequency devices. The films include a plurality of magnetic grains embedded in an amorphous matrix of stoichiometric ceramic with a high dielectric constant. This structure allows integrated inductors to be designed with smaller sizes and enhanced inductance and Q factor.

In accordance with one embodiment of the present invention, an inductive device comprises a conductor configured in a spiral and a first layer of granular magnetic material having a plurality of magnetic grains embedded in an amorphous ceramic matrix. The amorphous ceramic matrix has a dielectric constant greater than 3.

In accordance with another embodiment of the present invention, an integrated device comprises a first inductor trace and a first layer of granular magnetic material having a plurality of magnetic grains embedded in an amorphous ceramic matrix. The amorphous ceramic matrix has a dielectric constant greater than 3.

In accordance with another embodiment of the present invention, a transformer comprises a core and a first inductor. The first inductor includes a first conductor configured in a spiral surrounding a first portion of the core, and a first layer of granular magnetic material. The transformer further comprises a second inductor. The second inductor includes a second conductor configured in a spiral surrounding a second portion of the core, and a second layer of granular magnetic material. The first and second layers of granular magnetic material have a plurality of magnetic grains embedded in an amorphous ceramic matrix. The amorphous ceramic matrix has a dielectric constant greater than 3.

It is to be understood that both the foregoing summary of the invention and the following detailed description are exemplary and explanatory and are intended to provide further explanation of the invention as claimed.

### BRIEF DESCRIPTION OF THE DRAWINGS

The accompanying drawings, which are included to provide further understanding of the invention and are incorporated in and constitute a part of this specification, illustrate embodiments of the invention and together with the description serve to explain the principles of the invention. In the drawings:

Figure 1 illustrates an inductor in accordance with one embodiment of the present invention;

Figure 2 illustrates a partial cross-sectional view of an inductor in accordance with one embodiment of the present invention;

Figure 3 illustrates a plan view of a granular magnetic alloy having a plurality of magnetic grains embedded in an amorphous ceramic matrix in accordance with one embodiment of the present invention;

Figure 4 illustrates a perspective view of a granular magnetic alloy having a plurality of magnetic grains embedded in an amorphous ceramic matrix in accordance with one embodiment of the present invention;

Figure 5 illustrates an inductor in accordance with one embodiment of the present invention;

Figure 6 illustrates an inductor in accordance with one embodiment of the present invention;

Figure 7 illustrates a partial cross-sectional view of an inductor in accordance with one embodiment of the present invention;

Figure 8 illustrates an inductor in accordance with one embodiment of the present invention;

Figure 9 illustrates a partial cross-sectional view of an inductor in accordance with one embodiment of the present invention; and

Figure 10 illustrates a partial cross-sectional view of a transformer in accordance with one embodiment of the present invention.

### DETAILED DESCRIPTION OF THE INVENTION

In the following detailed description, numerous specific details are set forth to provide a full understanding of the present invention. It will be apparent, however, to one ordinarily skilled in the art that the present invention may be practiced without some of these specific details. In other instances, well-known structures and techniques have not been shown in detail to avoid unnecessarily obscuring the present invention.

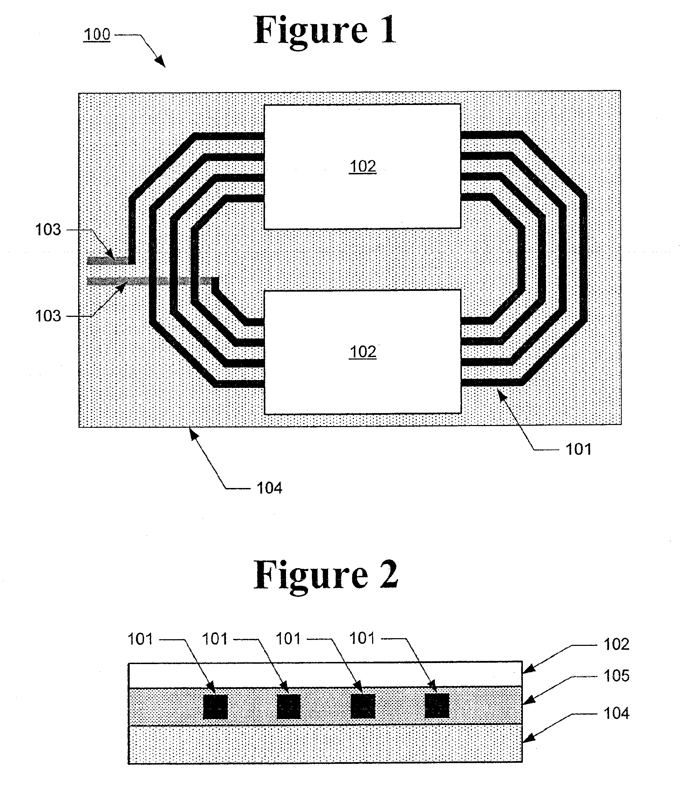

Figure 1 illustrates an inductor 100 in accordance with one embodiment of the present invention. Inductor 100, which is disposed on a silicon substrate 104, includes a conductor 101 configured in a spiral and terminated by conductor leads 103. As will be readily understood by one of skill in the art, conductor 101 may be provided by any one of a number of methods known to those of skill in the art, such as, for example, photolithography. In this regard, the conductor may be referred to herein as an inductor trace.

Inductor 100 further includes granular magnetic alloy layers 102 disposed above portions of conductor 101. Figure 2 illustrates in cross section one possible spatial relationship between granular magnetic alloy layer 102 and conductor 101 in accordance with one embodiment of the present invention. Granular magnetic alloy layer 102 is disposed over a dielectric layer 105 in which the turns of conductor 101 are disposed. Dielectric layer 105 is thereby sandwiched between granular magnetic alloy layer 102 and substrate 104. In one aspect, layers 102 and 105 form one or more thin films (e.g., films of less than about 1 micron in thickness).

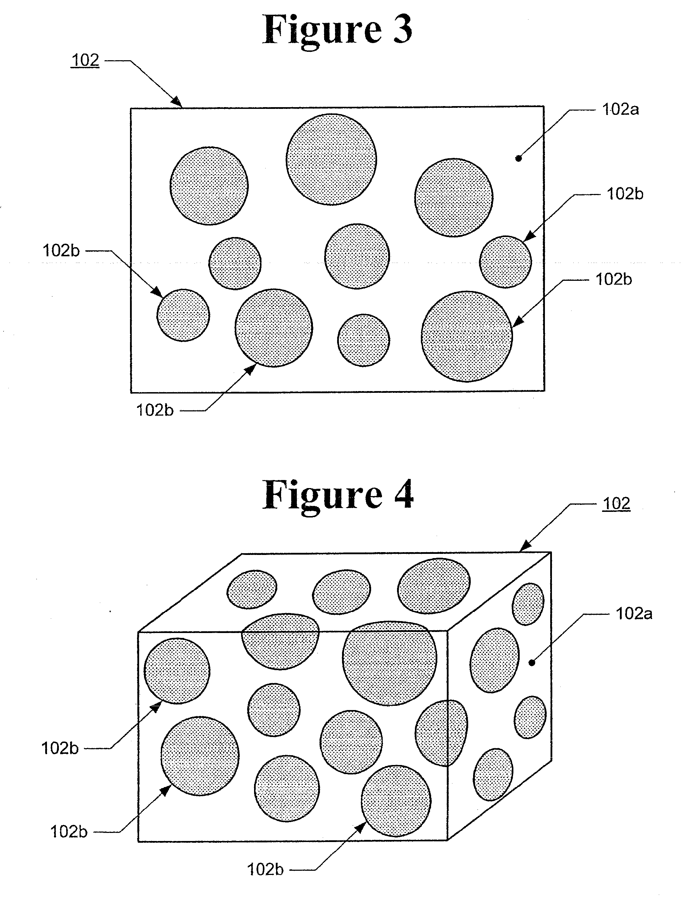

In one aspect of the present invention, each granular magnetic alloy layer 102 is a soft magnetic material which includes a plurality of magnetic grains embedded in an amorphous ceramic matrix, as illustrated in greater detail in Figure 3. According to one aspect, a soft magnetic material can be characterized by high permeability, high saturation magnetization or induction, high remanent magnetization or induction, low coercivity and low hysteresis loss. Additional desirable characters of soft magnetic materials may include high Curie temperatures and/or low magnetostriction. A ceramic matrix with an amorphous phase is utilized in the granular magnetic alloy, as amorphous phases show higher resistivity than crystalline phases, since electron conduction is typically facilitated by the grain boundaries in a crystalline phase. In accordance with another aspect of the present invention, a granular magnetic alloy layer is not limited to a soft magnetic material and can be another type of material. In accordance with yet another aspect of the present invention, a granular magnetic layer can be a material which is not an alloy.

In one aspect of the present invention, the ceramic matrix may comprise, for example, a stoichiometric material (e.g., if the ceramic material were a silicon oxide, the ratio of oxygen to silicon would be an integer ratio of, for example, 2:1, as opposed to 1.8:1). Any non-stoichiometry in the ceramic phase would either be electron (n-type) or hole (p-type) compensated, and would thus cause significant resistivity degradation (and concomitant higher eddy current losses at high frequency). Moreover, non-stoichiometry could generate paramagnetic charge centers (e.g., E'-type, *etc.*) which would increase the conductivity of the granular magnetic alloy, and thereby increase magnetic losses. Using an appropriately selected sputtering target (i.e., one with a desired amount of oxygen) in a reactive sputtering process (i.e., in the presence of oxygen), any potential non-stoichiometry can be compensated.

In Figure 3, granular magnetic alloy layer 102 is illustrated in partial cross-section, so that the individual magnetic grains 102b in the amorphous ceramic matrix 102a are visible. Each of magnetic grains 102b has a cross-sectional size between 5 and 50 nanometers in at least one dimension (e.g., columnar grains may have a cross-sectional size between 5 and 50 nanometers in one direction, but may be longer in the columnar direction). This microstructure reduces the undesirable eddy current losses experienced by non-granular magnetic films, thereby dramatically increasing their inductance (and their Q factor, as Q factor is a function of inductance) in high-frequency applications.

Amorphous ceramic matrix 102a forms a continuous three-dimensional structure, in accordance with one aspect of the present invention. This is shown in Figure 4, which provides a three-dimensional perspective view of granular magnetic alloy layer 102 in accordance with one embodiment of the present invention. As can be seen with reference to Figure 4, amorphous ceramic matrix 102a is a continuous structure (i.e., it is not divided into smaller discrete components by magnetic grains 102b). This continuity in the highly resistive amorphous phase ensures high volume resistivity (e.g., greater than 100 µΩ cm). To achieve this continuous structure, in accordance with one embodiment of the present invention, amorphous ceramic matrix 102a may be provided in an amount exceeding 10% by volume of granular magnetic alloy layer 102.

In accordance with one aspect of the present invention, magnetic grains 102b comprise a material selected from the group consisting of cobalt (Co), iron (Fe), nickel (Ni) and various alloys thereof. Table 1, below, provides an exemplary, non-exhaustive list of various ferromagnetic materials and alloys for use in granular magnetic alloys in accordance with one aspect of the present invention.

**Table 1**

| **Cobalt-based** | **Iron-based** | **Nickel-based** |
|---|---|---|
| Co | Fe | Ni |
| CoTaZr | FeCo | NiFe. |
| CoNbZr | FeCoB | NiFeCr |
| CoCrTa | FeCoTaZr | |
| CoCrTaZr | | |
| CoFeTaZr | | |
| CoNi | | |
| CoFe | | |
| CoFeB | | |

In accordance with one aspect of the present invention, amorphous ceramic matrix 102a comprises a material with a dielectric constant greater than about 3. For example, the amorphous ceramic matrix may be an oxide, a nitride, a carbide, a silicate, an aluminate, a Perovskite, or any combination thereof. Table 2, below, provides an exemplary, non-exhaustive list of various ceramic systems suitable for use in a granular magnetic alloy in accordance with one aspect of the present invention.

**Table 2**

| **Ceramic phase** | **Bulk Dielectric Constant at room temperature (RT)** |
|---|---|
| SiO₂ | 3.9 |
| MgO | 3.2 |
| Al₂O₃ | 10.5 |
| Ta₂O₅ | 30 |
| Nb₂O₅ | 50 |
| HfO₂ | 25 |
| ZrO₂ | 25 |
| TiO₂ | 60 |
| La₂O₃ | 20.8 |
| WO₃ | 20.2 |
| Y₂O₃ | 14 |
| CoO | 12.9 |
| V₂O₅ | 13.84 |
| HfSiO₄ | 12 |
| ZrSiO₂ | 12 |
| LaAlO₃ | ~15 |
| SrTiO₃ | 250 |
| BaTiO₃ | 500 |

Granular magnetic alloy layers 102 may be provided by any one of a number of methods, including physical vapor deposition (e.g., sputtering), in accordance with one aspect of the present invention. Accordingly, a sputter target comprising both the material of the magnetic grains and the material of the amorphous ceramic matrix may be sputtered over a spiral conductor to provide granular magnetic alloy layers over the desired regions of the package during fabrication, in accordance with one aspect of the present invention. Alternatively, two sputter targets, one comprising the material of the magnetic grains, the other comprising the material of the amorphous ceramic matrix, may both be sputtered at the same time and in the appropriate percentages (e.g., to provide an amorphous ceramic matrix of at least 10 % by volume of the resultant layer) to provide a desired granular magnetic alloy layer. As one of skill in the art would readily understand the methods by which a film of material may be sputtered in desired regions of an integrated package, a detailed description thereof is omitted to avoid unnecessarily obscuring the description of the various embodiments of the present invention.

Several advantages are enjoyed by an inductive device (e.g., an inductor, a transformer, *etc.*) employing a granular magnetic alloy layer in accordance with one embodiment of the present invention. For example, an integrated inductor with a soft granular magnetic alloy provides enhanced inductance and a concomitant improvement in the Q factor when compared to a non-granular magnetic alloy of similar size. Accordingly, granular magnetic alloy layers 102 may be designed to be significantly smaller than non-granular magnetic alloys having the same inductance and Q factor. Furthermore, as the magnetic flux is better confined within the granular magnetic alloy than in a non-granular magnetic alloy, cross-talk between multiple inductors on the same chip or package is minimized. These advantages render the various embodiments of the present invention suitable for use in a number of applications, including portable power delivery, wireless communication, and other applications.

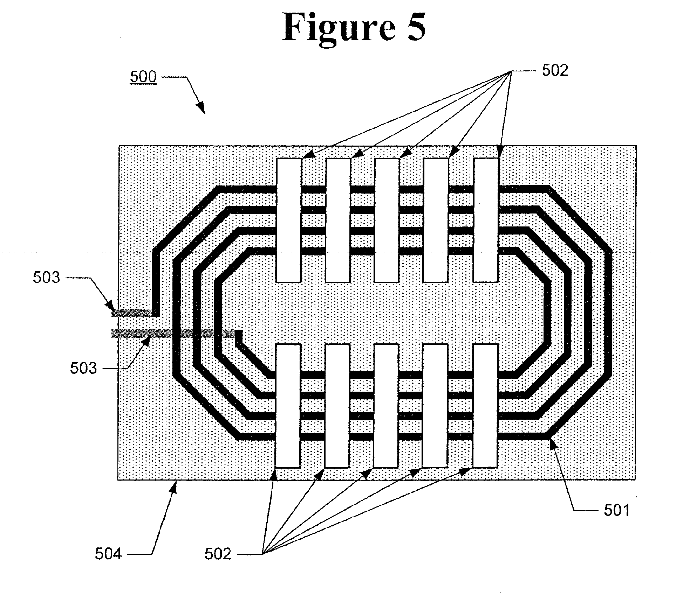

According to one aspect, the present invention is practiced with an integrated inductor having exactly two granular magnetic alloy layers in a single plane. The invention, however, is not limited to this configuration. For example, according to one aspect, the present invention has application to inductors with any number of granular magnetic alloy layers greater than or equal to one. For example, Figure 5 illustrates another inductor 500 in accordance with one embodiment of the present invention in which ten granular magnetic alloy layers 502 are provided along a spiral conductor 501. Similarly to the inductor illustrated in Figure 1, the conductor 501 of inductor 500 is terminated by conductor leads 503, and inductor 500 is disposed on a substrate 504.

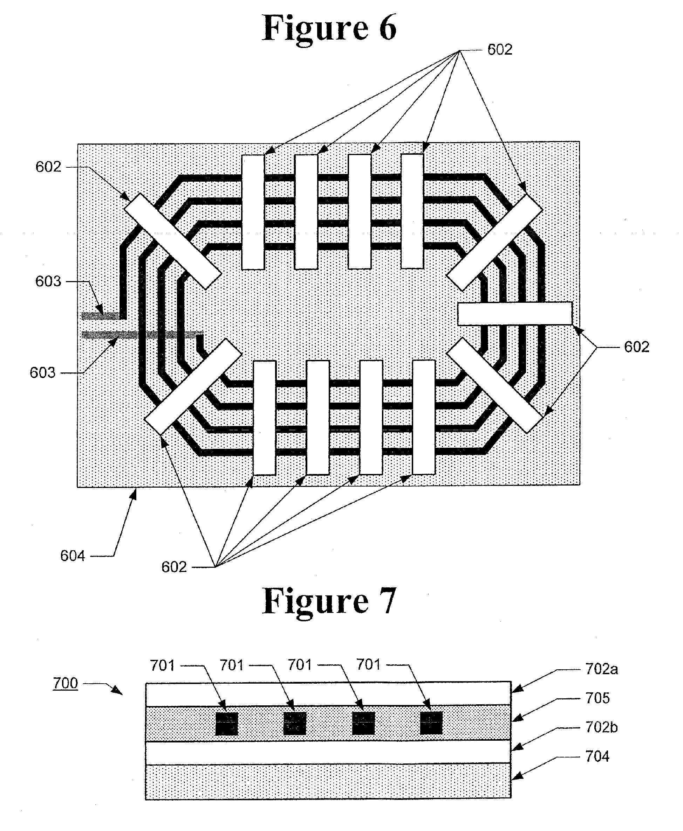

According to one aspect, a configuration of the present invention can include granular magnetic alloy layers disposed on opposing sides of an approximately octagonal spiral conductor. The scope of the present invention, however, is not limited to this particular arrangement. Rather, as will be apparent to one of skill in the art, the present invention also has application to inductors and transformers in which granular magnetic alloy layers are provided in any configuration around a conductor. For example, Figure 6 illustrates another inductor 600 in accordance with one embodiment of the present invention in which fourteen granular magnetic alloy layers 602 are spaced along the periphery of a spiral conductor 60I. The conductor 601 is terminated by conductor leads 603, and the entire inductor 600 assembly is disposed on a substrate 604.

According to one aspect, a configuration of the present invention includes granular magnetic alloy layers disposed in a single plane parallel to (*e.g*., above or below) the plane in which the spiral conductor is disposed. The scope of the present invention, however, is not limited to this particular arrangement. Rather, the present invention also has application to arrangements in which several layers of granular magnetic alloy are provided in different planes and/or in various relationships with an inductive trace. For example, Figure 7 illustrates a partial cross-sectional view of inductor 700 in accordance with an embodiment of the present invention in which portions of conductor 701 (disposed within dielectric layer 705) are sandwiched between two layers of granular magnetic alloy 702a and 702b in two different planes. While this multi-plane structure requires a more sophisticated fabrication than the single-plane structures previously described and illustrated, the effort may be justified by the further increase in the inductance and Q factor of an inductor so configured.

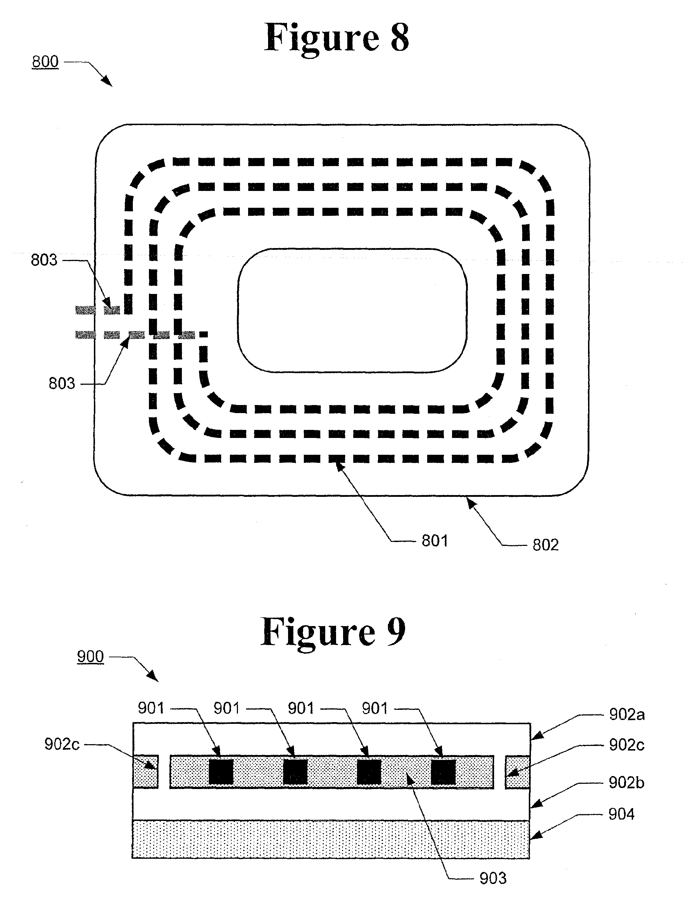

In another aspect, the present invention has application to arrangements in which a single granular magnetic alloy layer is disposed in one plane above or below the plane in which the spiral conductor is disposed, and the single granular magnetic alloy layer is large enough to cover the entire spiral conductor (instead of covering only certain sections of a conductor, as shown in Figures 1, 5 and 6). For example, Figure 8 illustrates an integrated inductor 800 in accordance with one embodiment of the present invention, in which one continuous conductor 801 (illustrated with a dotted line) configured in a spiral is disposed below a single continuous layer of granular magnetic alloy 802 which is large enough to cover the entire conductor 801. Conductor 801 is shown with a dotted line to illustrate that conductor 801 is hidden from the view because granular magnetic alloy layer 802 covers up the entire conductor 801. Conductor 801 is terminated by conductor leads 803.

As can be seen with reference to Figure 8, various embodiments of the present invention may be provided with conductors configured in a variety of different spirals. Instead of the approximately octagonal spiral illustrated in the previous exemplary embodiments, the spiral of Figure 8 is approximately rectangular, with rounded corners. The scope of the present invention is not, however, limited to these two configurations. Rather, as will be apparent to one of skill in the art, the present invention has application to inductors with conductors configured in spirals of any shape, whether elliptical, circular, polygonal, irregular, etc. Moreover, while the foregoing exemplary embodiments have been illustrated with substantially two-dimensional spirals (i.e., spirals lying in a single plane), the scope of the present invention is not limited to such an arrangement. According to one embodiment of the present invention, the term "spiral," as used herein, includes three-dimensional spirals (e.g., helices), such as those that may be used in integrated transformers, as described in detail below.

In accordance with one aspect of the present invention, Figure 9 illustrates a partial cross-sectional view of an integrated inductor 900 in which a conductor 901 disposed in a dielectric layer 903 is sandwiched between granular magnetic alloy layers 902a and 902b in two different planes. These three layers are together disposed on a substrate 904. The two layers of granular magnetic alloy 902a and 902b are connected by magnetic vias 902c. These magnetic vias 902c complete the circuit for the magnetic flux in the layers 902a and 902b of granular magnetic alloy, providing further improvement in the inductance and Q factor of the resultant inductor at high frequencies.

According to one aspect, a configuration of the present invention includes conductors disposed within a layer of dielectric material. The scope of the present invention, however, is not limited to such an arrangement. Rather, as will be apparent to one of skill in the art, the present invention also has application to inductors in which the conductor is disposed directly upon the substrate, in a layer of material that is not dielectric, in multiple layers, or within or alongside a granular magnetic alloy layer.

According to one aspect, a configuration of the present invention includes one inductor. The scope of the present invention, however, is not limited to such an arrangement. Rather, as will be apparent to one of skill in the art, the present invention also has application to multiple inductors and to any one or more inductive devices, including transformers and the like. For example, in accordance with another embodiment of the present invention, an integrated transformer includes two inductors, each having one or more layers of granular magnetic alloy configured to improve the inductance and Q factor thereof. The inductors of a transformer may be configured in planar spirals, as illustrated with respect to the foregoing exemplary embodiments, or may alternatively be configured in three-dimensional helices (e.g., so that a core lying substantially in a single plane can pass through both spirals).

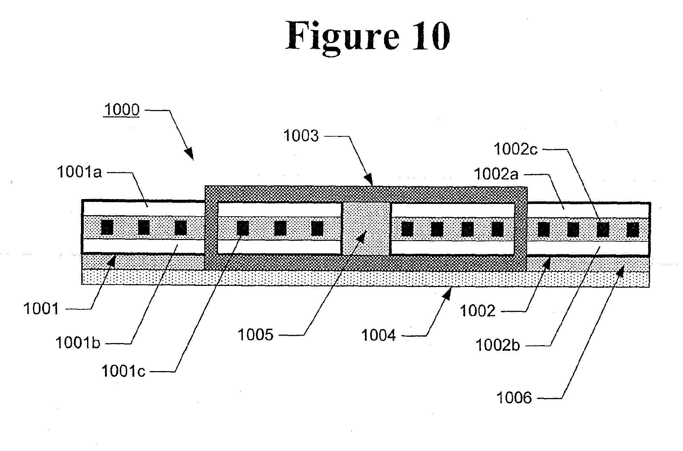

For example, Figure 10 illustrates a partial cross-sectional view of a transformer in accordance with one embodiment of the present invention. Transformer 1000 includes inductors 1001 and 1002 (outlined with a dark black line) disposed above a dielectric layer 1006 on a substrate 1004. Inductor 1001 includes a spiral conductor 1001c and two granular magnetic alloy layers 1001a and 1001b. Inductor 1002 includes a spiral conductor 1002c and two granular magnetic alloy layers 1002a and 1002b. Through the middle of the conductor spiral of each inductor 1001 and 1002 passes a core 1003 for concentrating magnetic flux. As can be seen with reference to Figure 10, inductor 1002 has more turns than inductor 1001. Accordingly, a voltage applied to inductor 1001 will be transformed to a higher voltage in inductor 1002 approximately in accordance with the ratio of the number of turns in inductor 1002 to inductor 1001 (e.g., 4/3 the voltage), as will be readily understood by one of skill in the art.

A transformer of the present invention is not limited to the configuration shown in Figure 10, and may be configured in a variety of ways. For example, instead of having two separate sets (1001a-1001b and 1002a-1002b) of granular magnetic alloy layers that are separated by a region 1005 as shown in Figure 10, the inductors of a transformer may share one or more granular magnetic alloy layers (e.g., granular magnetic alloy layer 1001 a may extend to granular magnetic alloy layer 1002a without a gap so that the two granular magnetic alloy layers 1001a and 1002a become one granular magnetic alloy layer). In another aspect, each of the inductors of a transformer may include only one granular magnetic alloy layer instead of multiple layers.

In yet another aspect, an inductor of the present invention may include multiple conductors. Moreover, the present invention is not limited to integrated inductors having only a single substrate layer and a single dielectric layer in which a conductor is disposed, but rather, as will be apparent to one of skill in the art, the present invention also has application to inductors with any number of additional layers not described or illustrated herein.

While the present invention has been particularly described with reference to the various figures and embodiments, it should be understood that these are for illustration purposes only and should not be taken as limiting the scope of the invention. There may be many other ways to implement the invention. Many changes and modifications may be made to the invention, by one having ordinary skill in the art, without departing from the spirit and scope of the invention.

## Claims

1. An inductive device comprising:
a conductor configured in a spiral; and
a first layer of granular magnetic material having a plurality of magnetic grains embedded in an amorphous ceramic matrix, the amorphous ceramic matrix having a dielectric constant greater than 3.

2. The inductive device of Claim 1, wherein at least a portion of the conductor is disposed within the first layer of granular magnetic material.

3. The inductive device of Claim 1, further comprising:
a layer of dielectric material in which at least a portion of the conductor is disposed,
wherein the first layer of granular magnetic material is coupled to the layer of dielectric material.

4. The inductive device of Claim l, wherein the first layer of granular magnetic material has a resistivity of greater than 100 µΩ cm.

5. The inductive device of Claim 1, wherein the spiral is disposed in a first plane parallel to a second plane in which the first layer of granular magnetic material is disposed.

6. The inductive device of Claim 5, further comprising:
a second layer of granular magnetic material having a second plurality of magnetic grains embedded in a second amorphous ceramic matrix, the second amorphous ceramic matrix having a dielectric constant greater than 3,
wherein the second layer of granular magnetic material is disposed in a third plane parallel to the first and second planes, and
wherein the second and third planes are on opposite sides of the first plane.

7. The inductive device of Claim 6, wherein the second layer of granular magnetic material and the first layer of granular magnetic material are connected by at least one magnetic via.

8. The inductive device of Claim 1, wherein the first layer of granular magnetic material is less than about 1 micron in thickness.

9. The inductive device of Claim 1, wherein each of the plurality of magnetic grains has a cross-sectional size between 5 and 50 nm.

10. The inductive device of Claim 1, wherein the amorphous ceramic matrix is continuously connected in three dimensions.

11. The inductive device of Claim 1, wherein the amorphous ceramic matrix comprises greater than 10 % by volume of the first layer of granular magnetic material.

12. The inductive device of Claim 1, wherein the amorphous ceramic matrix is stoichiometric.

13. The inductive device of Claim 1, wherein the plurality of magnetic grains comprises at least 50 atomic % of a material selected from the group consisting of cobalt (Co), iron (Fe), nickel (Ni) and any combination thereof.

14. The inductive device of Claim 1, wherein the plurality of magnetic grains comprise at least 50 atomic % of a material selected from the group consisting of Co, CoTaZr, CoNbZr, CoCrTa, CoCrTaZr, CoFeTaZr, CoNi, CoFe, CoFeB, Fe, FeCo, FeCoB, FeCoTaZr, Ni, NiFe and NiFeCr.

15. The inductive device of Claim 1, wherein the amorphous ceramic matrix comprises a material selected from the group consisting of an oxide, a nitride, a carbide, a silicate, an aluminate, a Perovskite, and any combination thereof.

16. The inductive device of Claim 1, wherein the amorphous ceramic matrix comprises a material selected from the group consisting of SiO₂, MgO, Al₂O₃, Ta₂O₅, Nb₂O₅, HfO₂, ZrO₂, TiO₂, La₂O₃, WO₃, Y₂O₃, CoO, V₂O₅, HfSiO₄, ZrSiO₂, LaAlO₃, SrTi0₃, BaTiO₃, and any combination thereof.

17. An integrated device, comprising:
a first inductor trace; and
a first layer of granular magnetic material having a plurality of magnetic grains embedded in a first amorphous ceramic matrix, the first amorphous ceramic matrix having a dielectric constant greater than 3.

18. The integrated device of claim 17, further comprising:
a second inductor trace; and
a second layer of granular magnetic material having a plurality of magnetic grains embedded in a second amorphous ceramic matrix, the second amorphous ceramic matrix having a dielectric constant greater than 3,
wherein the first and second inductor traces are operably coupled to form a transformer.

19. The integrated device of claim 18, wherein each of the first and second layer of granular magnetic material has a resistivity of greater than 100 µΩcm.

20. The integrated device of claim 18, wherein the first amorphous ceramic matrix is continuously connected in three dimensions and wherein the second amorphous ceramic matrix is continuously connected in three dimensions.

21. The integrated device of claim 18, wherein the first amorphous ceramic matrix comprises greater than 10 % by volume of the first layer of granular magnetic material, and wherein the second amorphous ceramic matrix comprises greater than 10 % by volume of the second layer of granular magnetic material.

22. The integrated device of claim 18, wherein the first and second amorphous ceramic matrices are stoichiometric.

23. A transformer comprising:
a core;
a first inductor including a first conductor configured in a spiral surrounding a first portion of the core and a first layer of granular magnetic material; and
a second inductor including a second conductor configured in a spiral surrounding a second portion of the core and a second layer of granular magnetic material;
wherein the first and second layers of granular magnetic material have a plurality of magnetic grains embedded in an amorphous ceramic matrix, the amorphous ceramic matrix having a dielectric constant greater than 3.
